# EUROPEAN PATENT SPECIFICATION

(11) **EP 0 437 960 B1**
(45) Date of publication and mention of the grant of the patent: **01.06.1994**
(21) Application number: 90314026.7
(22) Date of filing: 20.12.1990
(51) Int. Cl.: H02K 11/00, H01L 25/11

(54) **Rotating rectifier assembly**
Rotierende Gleichrichteranordnung
Assemblage rotatif de redresseurs

(30) Priority: 13.01.1990 GB 9000787
(43) Date of publication of application: 24.07.1991
(73) Proprietor: LUCAS INDUSTRIES PUBLIC LIMITED COMPANY, Solihull, West Midlands B91 3TX (GB)
(72) Inventor: Hayward, Dennis Richard, Bedfordshire, LU7 9AL (GB); Cooper, John, Hertfordshire, HP3 8PR (GB); Bomford, Raymond Richard, Chalfont St.Peter, Buckinghamshire (GB); Crickmore, Terence Leonard, Hemel Hempstead, Hertfordshire, HP3 8QN (GB)
(74) Representative: Chettle, Adrian John

(56) References cited:
- DE-A- 1 538 985
- FR-A- 2 164 711
- GB-A- 925 623
- US-A- 4 670 678
- PATENT ABSTRACTS OF JAPAN vol. 11, no. 65 (E-484)(2512) 27 February 1987, & JP-A-61 224848 (HITACHI) 6 October 1986,

## Description

This invention relates to rotating rectifier assemblies such as those used in alternators for aircraft auxiliary power units.

Rotating rectifier assemblies and the problems associated therewith are well known; such assemblies must be compact, robust and of sufficient strength to withstand the forces imparted by rotation at up to 25,000 r.p.m.

In one known arrangement rectification is provided between each phase of a three phase star wound generator winding and a common d.c. output (+ve); the star point of the generator winding provides the other d.c. output (-ve).

It has been found advantageous to also provide rectification between the star point and the common (+ve) d.c. output. In normal circumstances no current flows through the fourth rectifier; however in the event that the electrical supply from one or more of the phases is lost, the induced voltage is allowed to dissipate by recirculating current through the windings via the fourth rectifier.

Thus a rotating rectifier assembly according to this arrangement has four rectifiers.

Typically each rectifier comprises one or more diodes soldered to electrical conductors. In order to better withstand centrifugal forces it has been proposed to individually pre-load the electrical joints by means of springs. However, since the electrical resistance of each joint may depend on the pre-load applied, it has been found necessary to adopt means for equalising the pre-loads of each rectifier to ensure that the rectified output of each phase is substantially the same.

In one prior art rotating rectifier, three pairs of diodes are arranged between substantially circular conductors rotating together about a common axis. The pairs of diodes are 120° apart and have a pre-load applied by a single belleville washer; this arrangement ensures that the pre-load is shared equally by the equispaced diodes.

Difficulties arise with four rectifiers disposed in the same way since it is possible for three of the rectifiers to support a substantial proportion of the pre-load whilst the fourth carries little or no load.

According to the invention there is provided a rotatable rectifier comprising an electrically conductive baseplate rotatable about an axis and having a surface orthogonal to said axis, a plurality of substantially similar diodes extending axially from said surface and having an electrical connection thereto, each diode having one of a plurality of radially outwardly extending conductors at the free end thereof such that an electrical path from said conductors to said baseplate passes through said diodes, and the axially outer faces of the conductors being substantially co-planar; an insulating member covering said outer faces and having an axially outer face parallel to said surface, the diodes being capable of supporting an axial load between said baseplate and insulating member; and a spacing material between said faces and said insulating member for accommodating manufacturing tolerances. The spacing material ensures that the diodes share a pre-load equally as will be further described.

Preferably the diodes are of the silicon junction non-cavity Metoxilite bead type.

The baseplate forms a common electrical conductor for the diode output whilst electrical input is through the conductors. Each diode may in fact comprise a group of diodes between a common conductor and the baseplate thus enabling the number of individual diodes to be varied according to the power requirement of the rectifier.

In the preferred embodiment four groups of four bead type diodes are mounted around the baseplate.

In a preferred embodiment the rectifier further includes two or more spacers between said baseplate and insulating member, said spacers being fixed relative to one of the baseplate and insulating member and being located in the other with a clearance; a spacing material within said clearance holding each spacer relative to the other of said baseplate and insulating member. The spacers are preferably cylindrical, one end of each being force fitted in a corresponding bore of the baseplate and the other end of each being located in a corresponding bore of the insulating member. These spacers hold the baseplate and insulating member in circumferential alignment.

The baseplate and insulating member may be discs of substantially the same diameter, and each of a substantially constant thickness and having a respective aperture at the centre thereof.

In a preferred embodiment the spacing material comprises a cured compliant coating which allows for variation in manufacturing tolerances, as will be further described, so that when the assembly is clamped into a generator, each diode group supports an approximately equal proportion of the clamping load. The coating may also be an adhesive, and a suitable material is PERMABOND ESP 110 manufactured by Permabond Adhesives Limited of Eastleigh, Hampshire, England.

The assembly may further include an abutment for the axially outer face of said insulating member, a disc spring in abutment with the axially outer face of said baseplate, a clamping plate for said disc spring and means to draw the clamping plate and abutment together so as to compress said spring in use and thereby place the diodes under axial compression.

Such an arrangement allows the clamping load from the spring to be evenly distributed to each diode or group of diodes.

The rectifier assembly is relatively easy to construct, has a low mass and a low volume. The spring load is wholly axial thus eliminating any tendency for a radial component of spring force to urge the diodes outward as is the case with some prior art arrangements. In use the assembly is reliable and robust.

Preferably the disc spring comprises a belleville washer and the abutment comprises a rotatable component of a generator. The spring may be compressed by screws extending from the clamping plate to the abutment.

In a preferred embodiment two screws are provided, each extending through said clamping plate, baseplate and insulating member into tapped holes of the abutment.

Preferably said screws pass through the cylindrical spacers above-mentioned.

In the preferred embodiment an aperture extends through the centre of the clamping plate, baseplate and insulating member along the axis of rotation, a transfer tube for generator coolant extending through the aperture in use.

The invention also provides a method of assembly of a rotating rectifier and comprising the steps of:
soldering a plurality of substantially similar bead type diodes to one side of an electrically conducting baseplate;
soldering a plurality of conductors to the free ends of said diodes such that an electrical path from said conductors to said baseplate passes through said diodes, and said conductors are substantially co-planar;
applying a curable compliant coating to the outer faces of said conductors;
placing an insulating member against said coating; holding said baseplate and insulating member in a jig in a predetermined configuration; and
curing said coating to permanently hold the baseplate and insulating member in said predetermined configuration.

Preferably the method includes the intermediate steps of:
attaching a plurality of spacers on said one side of said baseplate;
applying a curable compliant coating to the free ends of said spacers; and
locating the free ends of said spacers with respect to said insulating member as the insulating member is placed against the coating on said conductors.

Other aspects of the invention will be apparent from the following description of a preferred embodiment shown by way of example only in the accompanying drawings in which:

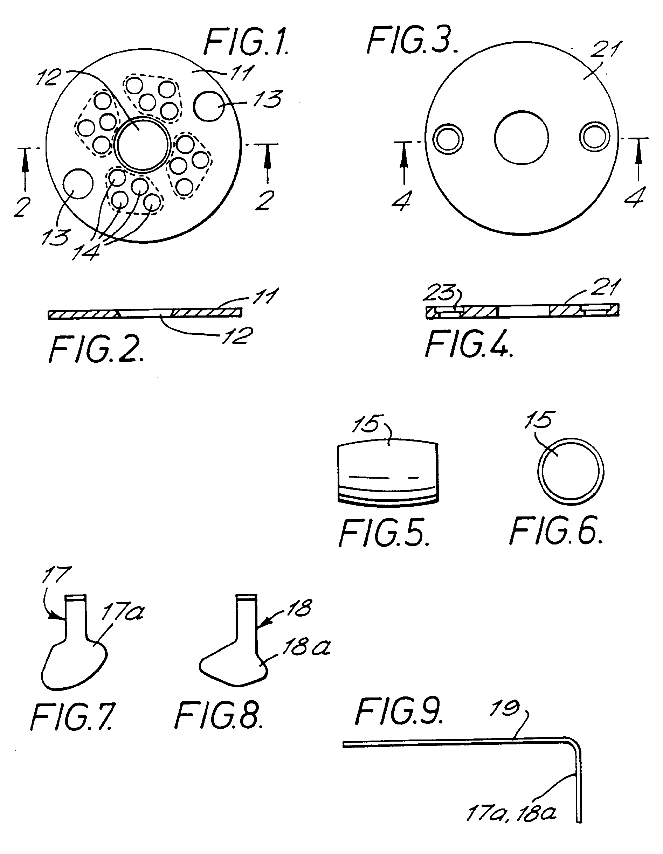

Fig 1 shows a baseplate in plan;
Fig 2 is an axial section through the baseplate of Fig 1 on line 2-2;
Fig 3 shows an insulating spacer in plan;
Fig 4 is an axial section through the spacer of Fig 3 on line 4-4;
Fig 5 is an enlarged elevation of a bead type rectifier;
Fig 6 is an end elevation of the rectifier of Fig 5;
Fig 7 is an end elevation of an electrical connector;
Fig 8 is an end elevation of an alternative electrical connector;
Fig 9 is a side elevation of the connector of Figs 7 and 8;
Fig 10 is a schematic isometric view of a partially constructed rectifier assembly;
Fig 11 is an axial section through a circular bush;
Fig 12 is an elevation of the rectifier assembly, in the direction of arrow A of Fig 10;
Fig 13 is an axial section through the assembly of Fig 12 on line 13-13;
Fig 14 is an enlarged scrap section corresponding to B of Fig 13;
Fig 15 is an enlarged scrap section corresponding to C of Fig 13;
Fig 16 is an axial section through a clamping plate;
Fig 17 is an elevation of the plate of Fig 16 in the direction of arrow D;
Fig 18 is an exploded view of a rectifier assembly for installation in a generator;
Fig 19 is a schematic illustration of an electrical circuit for the invention;
Fig 20 is a schematic illustration of a diode arrangement for the invention.

The rectifier assembly comprises a baseplate 11, of silver plated copper, having a central aperture 12, and a pair of diametrically opposite mounting holes 13; the aperture 12 is tapered as shown in Fig 13.

The baseplate 11 has on one side sixteen spotfaced recesses 14 arranged in groups of four as indicated.

Each recess 14 is of a diameter and depth suitable for locating a silicon junction, non-cavity Metoxilite bead type rectifier 15; four such rectifiers are provided in each group to permit a high current rating.

Connectors 17, 18 of silver plated beryllium copper provide an electrical connection from the free ends of each group of rectifiers as shown. Each connector comprises an end plate 17a, 18a and a free limb 19 extending around the baseplate and axially away therefrom.

The baseplate, rectifiers and connectors are assembled in a jig with solder pre-forms for the ends of the stud rectifiers; the jig ensures that the end plates 17a, 18a are substantially co-planar, and that the outerface of each end plate is substantially parallel to the outerface of the baseplate. The assembly is heated to melt the solder, as will be further described, and the solder is allowed to cool giving a good mechanical and electrical connection at each end of each rectifier.

A circular insulating spacer 21 of ULTEM polyetherimide resin covers the outer faces of the end plates as shown. The spacer 21 is supported by two shouldered hollow bushes 22, of PRIMEF polyphenylene sulfide, each located at one end in the mounting holes 13 and at the other end in a corresponding stepped hole 23 of the spacer 21.

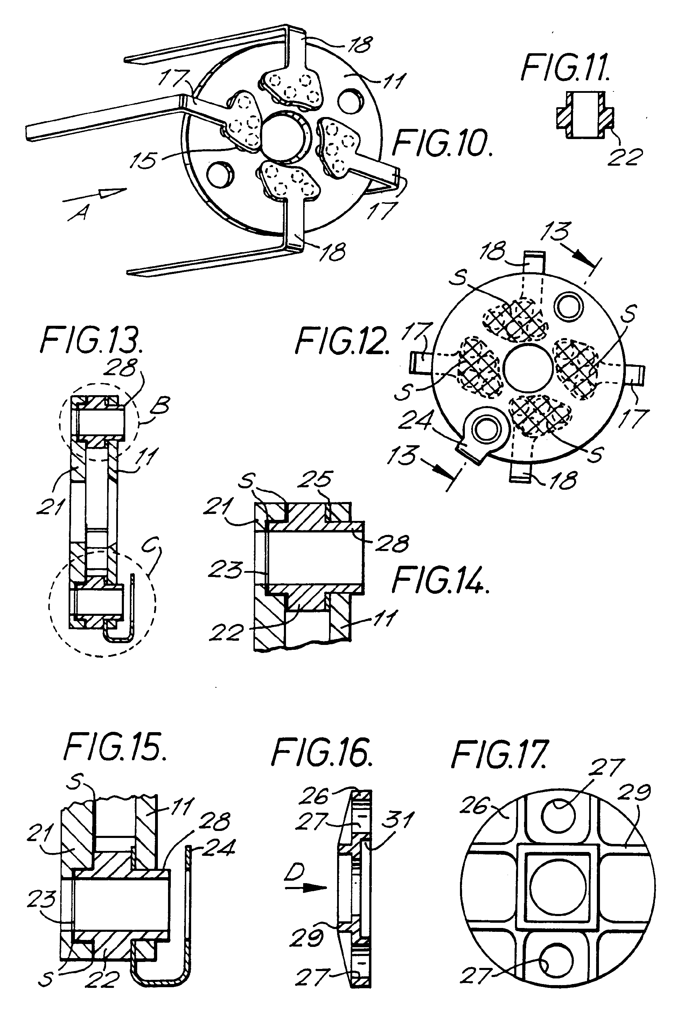

The bushes are an interference fit in the baseplate but have clearance in the holes 23 as indicated in Figs 14 and 15. During assembly of the spacer adhesive S is applied to the outer faces of the end plates 17a, 18a and to the free ends of the bushes as illustrated in Figs 12-15; the adhesive takes up the clearance and, on curing, holds the spacer securely in place as will be further described.

A tag connector 24 is provided under one of the bushes to provide an electrical path from the baseplate, and a corresponding washer 25 is provided under the other bush as shown in Figs 14 and 15.

An annular clamping plate 26, of aluminum alloy, includes apertures 27 to accommodate the protruding ends 28 of the bushes 22. The plate 26 has stiffening ribs 29 on one side and a recess 31 on the opposite side to accommodate a disc spring or belleville washer 32. On assembly, the disc spring provides a preload on the rectifiers as will be described below.

The method of assembly is as follows. The baseplate 11 is held horizontal whilst the rectifiers 15 and connectors 17, 18 are assembled thereto in a jig.

On completion of the soldering step, the tag 24 and washer 25 are positioned and the bushes 22 assembled into the baseplate 11; the spacer 21 is placed over the free ends of the bushes after adhesive has been applied to the contact faces of the bushes and connectors. A jig is used to ensure that the outer surfaces of baseplate and spacer are held parallel whilst the adhesive cures; variation in adhesive thickness accommodating manufacturing tolerances.

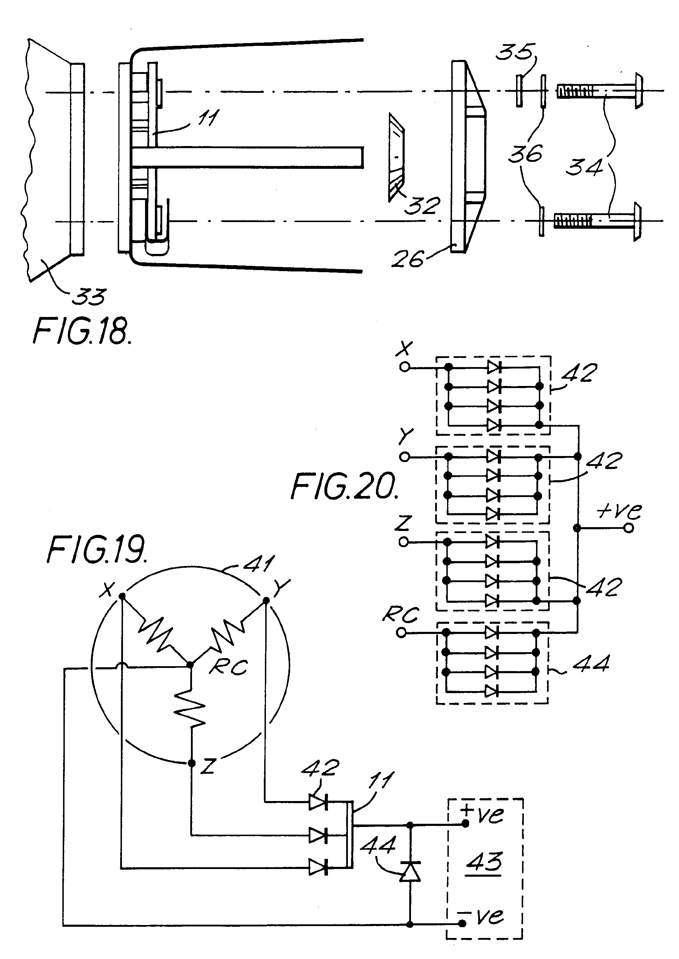

The rectifier assembly 30 is connected to a carrier as shown in Fig 18. The carrier 33 has locking screw-threaded inserts (not shown) to correspond with apertures 13. The clamping plate 26 is placed over the spring 32 and bolts 34 are passed through the aligned apertures 13, 23, 27 to clamp the rectifier assembly 30 to the carrier 33. A washer 35 corresponds to tag 24, and washers 36 lie immediately under the heads of the bolts 34.

In use a coolant transfer tube (not shown) passes through the central aperture of the assembly 30. Drive means, not shown, rotate the entire assembly. Electrical connection from the windings of the exciter rotor is through the connector arms 19. Electrical connection to the main generator windings is through the tag 24, and a second tag (not shown) which also lies under the head of bolt 34.

The material of the spacer 21 has a coefficient of expansion close to that of the baseplate 11, and the bushes 22 have a coefficient of expansion close to that of the bolts 34; this arrangement minimises internal stresses resulting from the high temperature at which the assembly may operate.

A schematic electrical circuit is shown in Fig 19. The exciter 41 is star wound and the output terminals are labelled X,Y,Z; each terminal (one for each phase) is connected through a diode 42 to the baseplate 11 which provides the +ve output to the main generator 43.

The star point, labelled RC, is connected through a fourth diode 44 to the baseplate output, or the baseplate 11 itself; current only flows through the fourth diode when the output from terminals X,Y and Z is interrupted.

The particular diode arrangement of the preferred embodiment is illustrated in Fig 20, four individual rectifiers being provided in parallel for each diode group.

## Claims

1. A rotatable rectifier comprising an electrically conductive baseplate (11) rotatable about an axis and having a surface orthogonal to said axis, a plurality of substantially similar diodes (42) extending axially from said surface and having an electrical connection thereto, each diode having one of a plurality of radially outwardly extending conductors (17,18) at the free end thereof such that an electrical path from said conductors to said baseplate passes through said diodes, and the axially outer faces of the conductors being substantially co-planar; an insulating member (21) covering said outer faces and having an axially outer face parallel to said surface, the diodes being capable of supporting an axial load between said baseplate (11) and insulating member (21); and a spacing material (S) between said faces and said insulating member for accommodating manufacturing tolerances.

2. A rectifier according to claim 1 and further including two or more spacers (22) between said baseplate (11) and insulating member (21), said spacers being fixed relative to one of the baseplate and insulating member and being located in the other with a clearance; a spacing material (S) within said clearance holding each spacer relative to the other of said baseplate and insulating member.

3. A rectifier according to claim 1 or claim 2 wherein said spacers (22) are cylindrical, one end of each being force fitted in a corresponding bore (13) of the baseplate (11) and the other end of each being located in a corresponding bore (23) of the insulating member (21).

4. A rectifier according to any preceding claim wherein said baseplate (11) and insulating member (21) are discs of substantially the same diameter, and each of a substantially constant thickness and having a respective aperture in the centre thereof.

5. A rectifier according to any preceding claim and further including an abutment for the axially outer face of said insulating member, resilient means (32) in abutment with the axially outer face of said baseplate, a clamping plate (26) in abutment with the axially outer face of said resilient means, and clamping means (34) to draw said clamping plate and abutment together thereby to place said diodes under axial load.

6. A rectifier according to any of claims 3-5 wherein said clamping means (34) comprise threaded rods passing one each through said spacers.

7. A rectifier according to any preceding claim wherein said spacing material (S) comprises a cured compliant coating.

8. A rectifier according to claim 7 wherein said coating comprises an adhesive.

9. A rectifier according to any preceding claim and including four groups of four bead type diodes (15), each group of diodes being connected to a respective conductor (17,18).

10. A rectifier according to any of claims 4-9 wherein said resilient means (32) comprises a single disc spring.

11. A rectifier according to any of claims 4-10 wherein said abutment comprises a rotatable component (33) of an electrical generator.

12. A method of assembly of a rotatable rectifier and comprising the steps of:
soldering a plurality of substantially similar bead type diodes (15) to one side of an electrically conducting baseplate;
soldering a plurality of conductors (17,18) to the free ends of said diodes such that an electrical path from said conductors to said baseplate (11) passes through said diodes (15), and said conductors are substantially co-planar;
applying a curable compliant coating (S) to the outer faces of said conductors;
placing an insulating member (21) against said coating;
holding said baseplate (11) and insulating member (21) in a jig in a predetermined configuration; and
curing said coating to permanently hold the baseplate and insulating member in said predetermined configuration.

13. A method according to claim 12 and including the intermediate steps of:
attaching a plurality of spacers (22) on said one side of said baseplate (11);
applying a curable compliant coating (S) to the free ends of said spacers (22); and
locating the free ends of said spacers (22) with respect to said insulating member (21) as the insulating member is placed against the coating (S) on said conductors (17,18).

## Patentansprüche

1. Rotierender Gleichrichter, welcher eine elektrisch leitende Grundplatte (11) aufweist, die um eine Achse drehbeweglich ist und eine zur Achse orthogonale Fläche hat, ferner eine Mehrzahl von im wesentlichen ähnlichen Dioden (42) aufweist, die axial von der Fläche weg verlaufen und eine elektrische Verbindung mit dieser haben, wobei jede Diode einen einer Mehrzahl von radial nach außen verlaufenden Leitern (17, 18) am freien Ende hiervon derart hat, daß ein elektrischer Pfad von den Leitern zu der Grundplatte durch die Dioden geht, und die axial äußere Flächen der Leiter im wesentlichen koplanar sind, welcher ferner ein Isolierteil (21) aufweist, welches die äußeren Flächen bedeckt und eine axiale äußere Fläche hat, die parallel zu dieser Fläche ist, wobei die Dioden eine axiale Belastung zwischen der Grundplatte (11) und dem Isolierteil (21) aufnehmen können, und ein Distanzmaterial (S) zwischen den Flächen und dem Isolierteil zum Ausgleich von Herstellungstoleranzen aufweist.

2. Gleichrichter nach Anspruch 1, welcher ferner zwei oder mehr Distanzteile (22) zwischen der Grundplatte (11) und dem Isolierteil (21) aufweist, die Distanzteile entweder relativ zur Grundplatte oder zum Isolierteil festgelegt sind und in dem jeweils anderen mit einem Spiel vorgesehen sind, und ein Distanzmaterial (S) in dem Zwischenraum das jeweilige Distanzstück relativ zu der Grundplatte oder dem Isolierteil hält.

3. Gleichrichter nach Anspruch 1 oder Anspruch 2, bei dem die Distanzteile (22) zylindrisch ausgebildet sind, ein Ende jedes Distanzteils kraftschlüssig in eine zugeordnete Bohrung (13) der Grundplatte (11) paßt, und das andere Ende jedes Distanzteils in einer zugeordneten Bohrung (23) des Isolierteils (21) liegt.

4. Gleichrichter nach einem der vorangehenden Ansprüche, bei dem die Grundplatte (11) und das Isolierteil (21) Scheiben mit im wesentlichen gleichem Durchmesser sind und jeweils eine im wesentlichen konstante Dicke sowie eine zugeordnete Öffnung in der Mitte hiervon haben.

5. Gleichrichter nach einem der vorangehenden Ansprüche, welcher ferner eine Auflage für die axiale äußere Fläche des Isolierteils, federnd nachgiebige Einrichtungen (32) in Anlage mit der axial äußeren Fläche der Grundplatte, eine Klemmplatte (26) in Anlage mit der axial äußeren Fläche der federnd nachgiebigen Einrichtung, und eine Klemmeinrichtung (34) umfaßt, um die Klemmplatte und die Auflage zusammenzuziehen, um die Dioden unter einer axialen Belastung anzuordnen.

6. Gleichrichter nach einem der Ansprüche 3 bis 5, bei dem die Klemmeinrichtung (34) mit Gewinde versehene Stangen aufweist, welche jeweils durch die Distanzteile gehen.

7. Gleichrichter nach einem der vorangehenden Ansprüche, bei dem das Distanzmaterial (S) einen gehärteten steifen Überzug aufweist.

8. Gleichrichter nach Anspruch 7, bei dem der Überzug einen Klebstoff aufweist.

9. Gleichrichter nach einem der vorangehenden Ansprüche, welcher ferner vier Gruppen aus vier Dioden (15) der Wulstbauart umfaßt und jede Gruppe von Dioden mit einem zugeordneten Leiter (17, 18) verbunden ist.

10. Gleichrichter nach einem der Ansprüche 4 bis 9, bei dem die federnd nachgiebige Einrichtung (32) eine einzige Scheibenfeder aufweist.

11. Gleichrichter nach einem der Ansprüche 4 bis 10, bei dem die Auflage eine drehbewegliche Komponente (33) eines elektrischen Generators aufweist.

12. Verfahren zum Zusammensetzen eines rotierenden Gleichrichters, welches die folgenden Schritte aufweist:
Anlöten einer Mehrzahl von im wesentlichen ähnlichen Dioden (15) der Wulstbauart an einer Seite einer elektrisch leitenden Grundplatte;
Anlöten einer Mehrzahl von Leitern (17, 18) an den freien Enden der Dioden derart, daß ein elektrischer Pfad von den Leitern zu der Grundplatte (11) durch die Dioden (15) geht und die Leiter im wesentlichen koplanar sind;
Aufbringen eines härtbaren, steifen Überzugs (S) auf den äußeren Flächen der Leiter;
Anlegen eines Isolierteils (21) gegen den Überzug;
Halten der Grundplatte (11) und des Isolierteils (21) in einer Montagevorrichtung in einer vorbestimmten Anordnung; und
Aushärten des Überzugs, um die Grundplatte und das Isolierteil in der vorbestimmten Anordnung ständig zu halten.

13. Verfahren nach Anspruch 12, welches ferner die folgenden Zwischenschritte aufweist:
Anbringen einer Mehrzahl von Distanzteilen (22) auf einer Seite der Grundplatte (11);
Aufbringen eines härtbaren, steifen Überzugs (S) auf den freien Enden der Distanzteile (22); und
Anordnen der freien Enden der Distanzteile (22) bezüglich des Isolierteils (21), wenn das Isolierteil gegen den Überzug (S) auf den Leitern (17, 18) gelegt wird.

## Revendications

1. Redresseur rotatif comprenant une plaque de base (11) électriquement conductrice pouvant tourner autour d'un axe et comportant une surface orthogonale à cet axe, une pluralité de diodes essentiellement semblables (42) partant axialement de cette surface et comportant un branchement électrique avec celle-ci, chaque diode comportant, à son extrémité libre, l'un d'une pluralité de conducteurs s'étendant radialement vers l'extérieur (17, 18) de façon qu'un chemin électrique allant des conducteurs à la plaque de base passe à travers les diodes, et les faces axialement extérieures des conducteurs étant essentiellement coplanaires ; un élément d'isolation (21) recouvrant les faces extérieures et comportant une face axialement extérieure parallèle à la surface orthogonale à l'axe, les diodes étant capables de supporter une charge axiale appliquée entre la plaque de base (11) et l'élément d'isolation (21) ; et un matériau d'espacement (S) placé entre les faces et l'élément d'isolation pour s'adapter aux tolérances de fabrication.

2. Redresseur selon la revendication 1, caractérisé en ce qu'il comprend en outre deux ou plusieurs pièces d'écartement (22) entre la plaque de base (11) et l'élément d'isolation (21), ces pièces d'écartement étant fixes par rapport à l'un ou l'autre de la plaque de base et de l'élément d'isolation, en étant placées dans l'autre avec un certain dégagement ; un matériau d'espacement (S) placé dans le dégagement maintenant chaque pièce d'écartement par rapport à l'autre de la plaque de base ou de l'élément d'isolation.

3. Redresseur selon l'une quelconque des revendications 1 ou 2, caractérisé en ce que les pièces d'écartement (22) sont cylindriques, une extrémité de chacune d'elles étant emboîtée de force dans un alésage correspondant (13) de la plaque de base (11), et l'autre extrémité de chacune d'elles étant placée dans un alésage correspondant (23) de l'élément d'isolation (21).

4. Redresseur selon l'une quelconque des revendications précédentes, caractérisé en ce que la plaque de base (11) et l'élément d'isolation (21) sont des disques essentiellement de même diamètre, présentant chacun une épaisseur essentiellement constante, et comportant respectivement une ouverture en leur centre.

5. Redresseur selon l'une quelconque des revendications précédentes, caractérisé en ce qu'il comprend en outre une butée pour la face axialement extérieure de l'élément d'isolation, des moyens élastiques (32) en butée contre la face axialement extérieure de la plaque de base, une plaque de blocage (26) en butée contre la face axialement extérieure des moyens élastiques, et des moyens de serrage (34) pour tirer la plaque de blocage contre la butée de manière à placer ainsi les diodes sous une charge axiale.

6. Redresseur selon l'une quelconque des revendications 3 à 5, caractérisé en ce que les moyens de serrage (34) comprennent des tiges filetées passant chacune à travers les pièces d'écartement.

7. Redresseur selon l'une quelconque des revendications précédentes, caractérisé en ce que le matériau d'espacement (S) comprend un revêtement souple durci.

8. Redresseur selon la revendication 7, caractérisé en ce que le revêtement comprend un adhésif.

9. Redresseur selon l'une quelconque des revendications précédentes, caractérisé en ce qu'il comprend quatre groupes de quatre diodes de type à perle (15), chaque groupe de diodes étant branché à un conducteur respectif (17, 18).

10. Redresseur selon l'une quelconque des revendications 4 à 9, caractérisé en ce que les moyens élastiques (32) comprennent un disque de ressort unique.

11. Redresseur selon l'une quelconque des revendications 4 à 10, caractérisé en ce que la butée comprend un élément rotatif (33) d'un générateur électrique.

12. Procédé de montage d'un redresseur rotatif, caractérisé en ce qu'il comprend les étapes consistant à :
souder une pluralité de diodes de type à perle essentiellement semblables (15), à un côté d'une plaque de base électriquement conductrice ;
souder une pluralité de conducteurs (17, 18) aux extrémités libres des diodes de façon qu'un chemin électrique allant des conducteurs à la plaque de base (11) passe à travers les diodes (15), et que les conducteurs soient essentiellement coplanaires ;
appliquer un revêtement souple durcissable (S) sur les faces extérieures des conducteurs ;
placer un élément d'isolation (21) contre le revêtement ;
maintenir la plaque de base (11) et l'élément d'isolation (21) dans une configuration prédéterminée à l'intérieur d'un gabarit ; et
faire durcir le revêtement pour maintenir de façon permanente la plaque de base et l'élément d'isolation dans la configuration prédéterminée.

13. Procédé selon la revendication 12, caractérisé en ce qu'il comprend les étapes intermédiaires consistant à :
fixer une pluralité de pièces d'écartement (22) sur le côté de la plaque de base (11) ;
appliquer un revêtement souple durcissable (S) sur les extrémités libres des pièces d'écartement (22) ; et
positionner les extrémités libres des pièces d'écartement (22), par rapport à l'élément d'isolation (21), de la même manière que l'élément d'isolation est placé contre le revêtement (S) sur les conducteurs (17, 18).
